# EUROPEAN PATENT APPLICATION

(11) **EP 4 113 834 A1**
(43) Date of publication of application: **04.01.2023**
(21) Application number: 21183060.9
(22) Date of filing: 01.07.2021
(51) Int. Cl.: H03F 3/19, H03F 3/45

(54) **RADIO FREQUENCY RECEIVER ASSEMBLY WITH LOW NOISE AMPLIFIER**

(71) Applicant: Koninklijke Philips N.V., 5656 AG Eindhoven (NL)
(72) Inventor: SHRESTHA, Rameswor, 5656 AE Eindhoven (NL); TOTEV, Emil Dimitrov, 5656 AE Eindhoven (NL); OUZOUNOV, Sotir Filipov, 5656 AE Eindhoven (NL)
(74) Representative: Philips Intellectual Property & Standards

(57) **Abstract**

A radio frequency receiver assembly for a magnetic resonance imaging system comprising a low noise amplifier, LNA, circuit (1) comprising: a first differential pair of transistors (2) of a first conductivity-type, a first tail current source (6), a second differential pair of transistors (3) of a second conductivity-type, a pair of inputs for respectively receiving a first input voltage (Vᵢₙₚ) and a second input voltage (Vᵢₙₙ), a second tail current source (7), the LNA circuit (1) further comprising a first cascode stage (4) comprising at least two transistors of the first conductivity-type, wherein the first cascode stage (4) is arranged between the first differential pair of transistors (2) and a differential output (outp, outn), the LNA circuit further comprising a second cascode stage (5) comprising at least two transistors of the second conductivity-type, wherein the second cascode stage (5) is arranged between the the second differential pair of transistors (3) and the differential output (outp, outn), wherein the LNA circuit (1) comprises a common mode feedback circuit (8) configured to drive the first current source (6).

## Description

### FIELD OF THE INVENTION

The invention relates to the field of radio frequency RF receiver assemblies for a magnetic resonance imaging system and in particular to a low noise amplifier LNA circuit for a radio frequency RF receiver assembly. The invention also relates to magnetic resonance imaging system comprising a radio frequency RF receiver assembly with a low noise amplifier LNA circuit.

### BACKGROUND OF THE INVENTION

A Low Noise Amplifier (LNA) is the key building block in any MRI receiver system to ensure low noise figure of the receiver in order to obtain the best possible image quality. A typical MR receiver consists of an RF receive coil, matching network, LNA (or preamp) and analog-to-digital conversion circuit. The RF receive coil in the MR system detects the induced current from precessing magnetization via electromagnetic induction. The LNA or preamplifier increases the amplitude of the received signal to a level that can be further processed.

LNA design for MR comes with many stringent requirements all at the same time. The LNA is often one of the most power-hungry circuits that is close to the sensor and respectively the sample, as significant bias current is required to achieve very low noise figure (<0.5dB) and high gain. With the recent advancement in in-coil digitized MR receiver systems, it is more and more important to realize low power LNA to make those concepts practically feasible. On the other hand, an LNA uses a number of chokes to bias its input/output, primarily to have the lowest noise contribution from the biasing circuits. However, these components are physically big and need shielding. Furthermore, the LNA is the component in the MR receiver that has the highest stability risk because of poor isolation between the output and the input and because the LNA input is not typically power matched but only noise matched to avoid coupling between coils in the array configuration. Moreover, the MR signal has very high dynamic range, which means that the LNA needs to be linear for a large input power range. Another important aspect that affects the image quality is the phase and gain stability across temperatures as MR signal acquisition takes a long time. Since almost all LNAs in this application are open loop designs because of extremely low noise figure requirement, the gain/phase of the amplified MR signal is a function of temperature.

### SUMMARY OF THE INVENTION

It is an object of the invention to provide a choke-less, low power and temperature compensated low noise amplifier that can simultaneously achieve low noise, high linearity and high reverse isolation.

According to the invention, this object is addressed by the subject matter of the independent claims. Preferred embodiments of the invention are described in the sub claims.

Therefore, according to the invention, a radio frequency RF receiver assembly for a magnetic resonance imaging system is foreseen, the RF receiver assembly comprising:
a low noise amplifier LNA circuit, wherein the LNA circuit is a differential amplifying circuit the LNA circuit comprising:
a first differential pair of transistors of a first conductivity-type, having a pair of inputs for respectively receiving a first input voltage and a second input voltage, the first differential pair of transistors having a first tail current source,
a second differential pair of transistors, of a second conductivity-type, having a pair of inputs for respectively receiving the first input voltage and the second input voltage, the second differential pair of transistors having a second tail current source,
the first tail current source and the second tail current source are connected to the first differential pair of transistors and the second differential pair of transistors in an inverted configuration,
the LNA circuit further comprising a first cascode stage comprising at least two transistors of the first conductivity-type, wherein the first cascode stage is arranged between the first differential pair of transistors and the differential output,
the LNA circuit further comprising a second cascode stage comprising at least two transistors of the second conductivity-type, wherein the second cascode stage is arranged between the second differential pair of transistors and the differential output,
wherein the LNA circuit comprises a common mode feedback circuit wherein the LNA circuit is configured to set a common mode voltage at the outputs as a reference voltage for the common mode feedback circuit, wherein the common mode feedback circuit is configured to drive the first current source,
the LNA circuit further comprising a temperature compensation circuit, wherein the temperature compensation circuit is configured to set the second tail current source proportional to the temperature.

This invention proposes a choke-less, low power LNA circuit that can simultaneously achieve low noise, high linearity and high reverse isolation. The invention combines various circuit design techniques in a unique way to solve various MR specific challenges, thereby achieving high performance LNA. The invention is highly suited for in-coil digitized MR receiver systems. The basic idea behind is that the LNA circuit consist of first and second differential pair of transistors of a first and scond conductivity-type with tail current sources connected in an inverted configuration. Furthermore, the first cascode stage and the second cascode stage are used to increase the isolation between the output and the input, without adding any noise to the output. The off-chip matching network (not shown in the figures) is required to convert the impedance of the sample to the optimum impedance of the LNA.

In an embodiment of the invention the transistors of the first conductivity-type are of PMOS type and the transistors of the second conductivity-type are of NMOS type.

In another embodiment of the invention each input of the pair of inputs is connected between the first differential pair of transistors and the second differential pair of transistors by a decoupling capacitor. The use of the decoupling capacitors ensures that the input voltage range is large enough.

In an embodiment of the invention the common mode feedback circuit comprises a common mode derivation and an amplifier, wherein the amplifier is configured to drive the first current source.

In another embodiment of the invention the LNA circuit does not contain any frequency dependent component to enable the use of the same LNA circuit for multiple imaging modes and field strength of the magnetic resonance imaging system.

In an embodiment of the invention the first tail current source is programable to provide computer programmable gain to the LNA circuit.

In a further aspect of the invention a computer program product comprising instructions is foreseen which, when the program is executed by a computer, cause the computer to change the gain of the LNA circuit of the RF receiver assembly as described above.

In another aspect of the invention, the object is achieved by a magnetic resonance imaging system comprising a radio frequency (RF) receiver assembly as described above.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 shows an MRI signal chain of a radio frequency RF receiver assembly for a magnetic resonance imaging system according to an embodiment of the invention,
Fig. 2 shows a conceptual schematic of a choke-less LNA consisting of PMOS and NMOS differential pairs according to an embodiment of the invention,
Fig. 3 shows a circuit diagram of a choke-less LNA according to another embodiment of the invention.

### DETAILED DESCRIPTION OF EMBODIMENTS

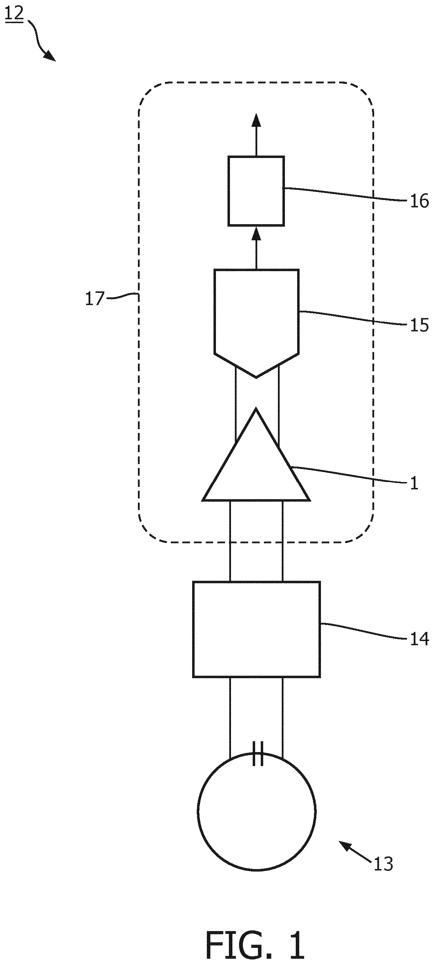

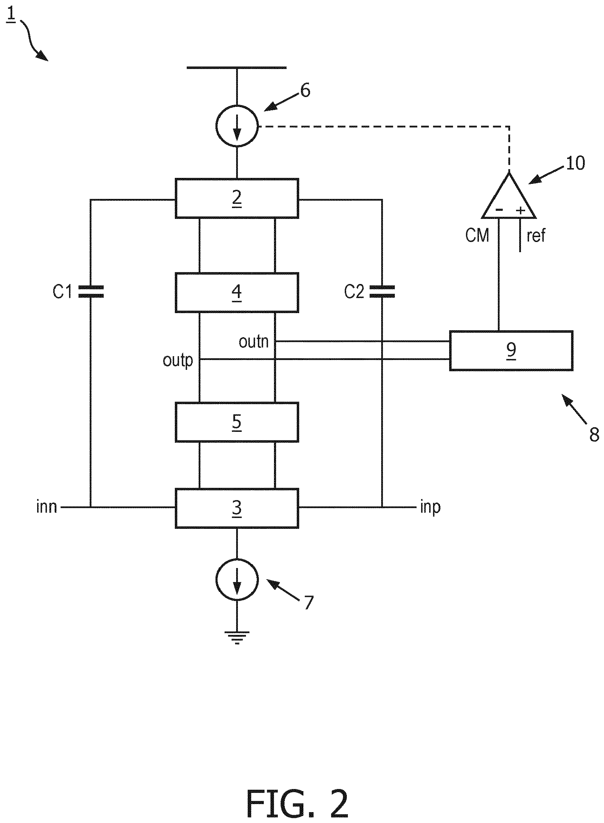

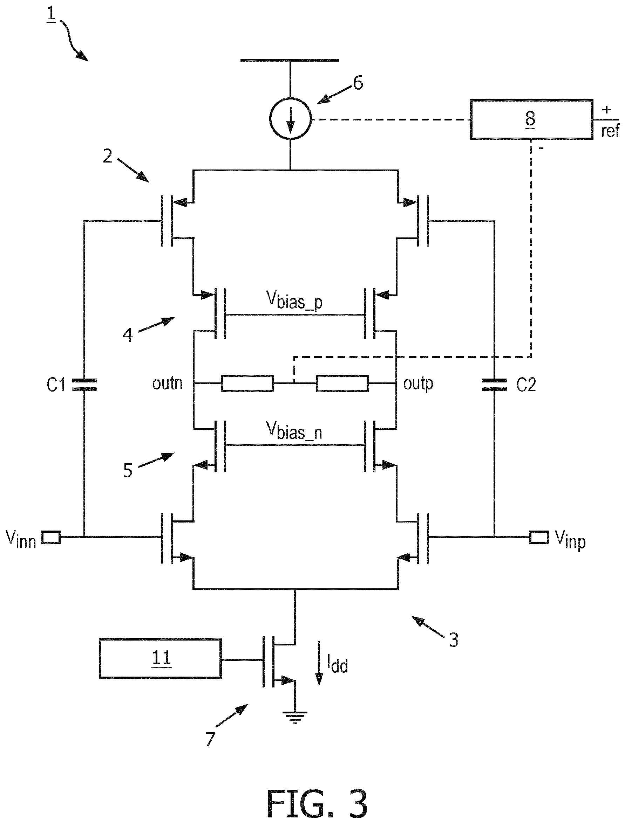

Fig. 1 shows an MRI signal chain of a radio frequency RF receiver assembly 12 for a magnetic resonance imaging system. The RF receiver assembly 12 comprises at least one RF coil 13 for receiving an analog MR information signal. The RF receiver assembly 12 further comprises a matching network 14 which matches the impedance of the RF coil 13 with the impedance of RF circuits for detecting the analog MR information signal. The analog MR information signal is amplified by a low noise amplifier (LNA) 1. The LNA 1 in this embodiment is a choke-less LNA circuit 1 as described e.g., in the embodiments in Fig. 2 and 3. The amplified MR information signal is propagated to an analog to a digital converter (ADC) 15 to convert the analog signal into a digital signal. The digitized signal is then passed to further digital circuits 16 for further signal processing. The LNA, the ADC and the further digital circuits can be e.g., monolithically integrated 17.

Fig. 2 shows a conceptual schematic of a choke-less LNA circuit 1 of a radio frequency receiver assembly 12 according to an embodiment of the invention. The LNA circuit 1 shown in Fig. 2 is a differential amplifying circuit. The LNA circuit 1 comprises a first differential pair of transistors 2 of a first conductivity-type, having a pair of inputs inp, inn for respectively receiving a first input voltage Vᵢₙₚ and a second input voltage Vᵢₙₙ and a second differential pair of transistors 3 of a second conductivity-type, having a pair of inputs inp, inn for respectively receiving the first input voltage Vᵢₙₚ and the second input voltage Vᵢₙₙ. In an embodiment of the invention the transistors of the first differential pair of transistors 2 of the first conductivity-type are of PMOS type and the transistors of the second differential pair of transistors 3 of the second conductivity-type are of NMOS type. The first differential pair of transistors 2 have a first tail current source 6 and the second differential pair of transistors 3 have a second tail current source 7, wherein the first tail current source 6 and the second tail current source 7 are connected to the first differential pair of transistors 2 and the second differential pair of transistors 3 in an inverted configuration. The LNA circuit 1 comprises a common mode feedback circuit 8 wherein the LNA circuit 1 is configured to set a common mode voltage at the outputs outp, outn as a reference voltage ref for the common mode feedback circuit 8. wherein the common mode feedback circuit 8 is configured to drive the first current source 6. The common mode feedback circuit 8 consists of a common mode derivation 9 and an amplifier 10 that drives the tail current source 6 of the PMOS differential pair 2. This eliminates the requirement for the RF choke biasing at the output. Furthermore, the use of the decoupling capacitors C1, C2 ensures that the input voltage range (dynamic range) is large enough. In other word, the decoupling of the inputs inn, inp for the PMOS differential pair 2 increases the linearity range of the LNA circuit 1. The LNA circuit 1 further comprising a first cascode stage 4 comprising at least two transistors of the first conductivity-type, wherein the first cascode stage 4 is arranged between the first differential pair of transistors 2 and the differential output outp, outn. The LNA circuit further comprising a second cascode stage 5 comprising at least two transistors of the second conductivity-type, wherein the second cascode stage 5 is arranged between the second differential pair of transistors 3 and the differential output outp, outn. The cascode NMOS and PMOS pairs 4, 5 are used to increase the isolation between the output outp, outn and the input inn, inp, known as reverse isolation. Sufficient reverse isolation helps to design unconditionally stable LNAs. The LNA circuit 1 further comprises a temperature compensation circuit 11, wherein the temperature compensation circuit 11 is configured to set the second tail current source 7 proportional to the temperature. Due to the invention the following circuit blocks of the choke-less LNA circuit 1 do not contribute to the output noise, the common mode feedback circuit 8 with the common mode derivation 9 and the amplifier 10, the first tail current source 6 and the second tail current source 7, the first cascode stage 4 and the second cascode stage 5. Therefore, the only components shown in Fig. 2 that contribute to the noise are the input differential pairs 2, 3 which are the minimum possible noise contributing (amplifying) components in the circuit 1. In any LNA design, high current (in the order of several mA to 10s of mA) is required in the core amplifying part of the circuit to reduce the noise. However, in the proposed LNA circuit 1, the same current flows through both NMOS and PMOS input differential pairs 2, 3. Since in magnetic resonance application LNA core current is often a major part of the receiver current consumption, this current reuse technique almost halves the current consumption for the same gain and noise, achieving a low power LNA.

Fig. 3 shows a circuit diagram of a choke-less LNA circuit 1 with components according to another embodiment of the invention. The first differential pair of transistors 2 consists of two PMOS type transistors. The second differential pair of transistors 3 consists of two NMOS type transistors. The first cascode stage 4 and the second cascode stage 5 each also consist of two transistors, wherein the first cascode stage 4 consists of two PMOS type transistors and the second cascode stage 5 consists of two NMOS type transistors. In any LNA, as the temperature rises the gain drops and the delay increases because of the lower electron mobility of the device. In the proposed LNA circuit 1, such gain/phase change is compensated by designing the second tail current source 7 reference that is proportional to the temperature. In the embodiment of the invention shown in Fig. 3 this is done by a temperature compensation circuit 11. This improves the image quality across temperature variations.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

**REFERENCE SYMBOL LIST**

| | |
|---|---|
| low noise amplifier circuit | 1 |
| PMOS differential pair | 2 |
| NMOS differential pair | 3 |
| PMOS cascode stage | 4 |
| NMOS cascode stage | 5 |
| first current source | 6 |
| second current source | 7 |
| common mode feedback circuit | 8 |
| common mode derivation | 9 |
| amplifier | 10 |
| temperature compensation circuit | 11 |
| radio frequency RF receiver assembly | 12 |
| coil | 13 |
| matching network | 14 |
| ADC | 15 |
| digital circuits | 16 |
| monolithic integration | 17 |
| decoupling capacitor | C1 |
| decoupling capacitor | C2 |
| common mode | CM |
| differential input | inn |
| differential input | inp |
| differential output | outn |
| differential output | outp |
| reference voltage | ref |
| input voltage | Vᵢₙₙ |
| input voltage | Vᵢₙₚ |
| supply current | I_{dd} |
| bias voltage | V_{bias_n} |
| bias voltage | V_{bias_p} |

## Claims

1. A radio frequency RF receiver assembly for a magnetic resonance imaging system, the RF receiver assembly (12) comprising:
a low noise amplifier LNA circuit (1), wherein the LNA circuit (1) is a differential amplifying circuit the LNA circuit (1) comprising:
a first differential pair of transistors (2) of a first conductivity-type, having a pair of inputs (inp, inn) for respectively receiving a first input voltage (Vᵢₙₚ) and a second input voltage (Vᵢₙₙ), the first differential pair of transistors (2) having a first tail current source (6),
a second differential pair of transistors (3), of a second conductivity-type, having a pair of inputs (inp, inn) for respectively receiving the first input voltage (Vᵢₙₚ) and the second input voltage (Vᵢₙₙ), the second differential pair of transistors (3) having a second tail current source (7),
the first tail current source (6) and the second tail current source (7) are connected to the first differential pair of transistors (2) and the second differential pair of transistors (3) in an inverted configuration,
the LNA circuit (1) further comprising a first cascode stage (4) comprising at least two transistors of the first conductivity-type, wherein the first cascode stage (4) is arranged between the first differential pair of transistors (2) and the differential output (outp, outn),
the LNA circuit further comprising a second cascode stage (5) comprising at least two transistors of the second conductivity-type, wherein the second cascode stage (5) is arranged between the second differential pair of transistors (3) and the differential output (outp, outn),
wherein the LNA circuit (1) comprises a common mode feedback circuit (8) wherein the LNA circuit (1) is configured to set a common mode voltage at the outputs (outp, outn) as a reference voltage (ref) for the common mode feedback circuit (8), wherein the common mode feedback circuit (8) is configured to drive the first current source (6),
the LNA circuit (1) further comprising a temperature compensation circuit (11), wherein the temperature compensation circuit (11) is configured to set the second tail current source (7) proportional to the temperature.

2. The radio frequency RF receiver assembly according to claim 1, wherein
the transistors of the first differential pair of transistors (2) of the first conductivity-type are of PMOS type and the transistors of the second differential pair of transistors (3) of the second conductivity-type are of NMOS type.

3. The radio frequency RF receiver assembly according to any preceding claim, wherein
each input (inn, inp) of the pair of inputs is connected between the first differential pair of transistors (2) and the second differential pair of transistors (3) by a decoupling capacitor (C1, C2).

4. The radio frequency RF receiver assembly according to any preceding claim, wherein the common mode feedback circuit (8) comprises a common mode derivation (9) and an amplifier (10), wherein the amplifier (10) is configured to drive the first current source (6).

5. The radio frequency RF receiver assembly according to any preceding claim, wherein
the LNA circuit (1) does not contain any frequency dependent component to enable the use of the same LNA circuit (1) for multiple imaging modes and field strength of the magnetic resonance imaging system.

6. The radio frequency RF receiver assembly according to any preceding claim, wherein
the first tail current source (6) is programable to provide computer programmable gain to the LNA.

7. A computer program product comprising instructions which, when the program is executed by a computer, cause the computer to change the gain of the LNA circuit (1) of the RF receiver assembly (12) according to claim 6.

8. A magnetic resonance imaging system, the magnetic resonance imaging system comprising a radio frequency RF receiver assembly (12) according to claims 1 to 6.
